Europäisches Patentamt

European Patent Office

Office européen des brevets

(11) Veröffentlichungsnummer: **0 353 616 B1**

# EUROPÄISCHE PATENTSCHRIFT

(45) Veröffentlichungstag der Patentschrift: **08.12.93**

(21) Anmeldenummer: **89113796.0**

(22) Anmeldetag: **26.07.89**

(51) Int. Cl.⁵: **H04L  7/00**, H04J 3/06

(54) Verfahren zur Synchronisation eines Taktes auf störbehaftete Referenztakte.

(30) Priorität: **02.08.88 DE 3826249**

(43) Veröffentlichungstag der Anmeldung:
**07.02.90 Patentblatt  90/06**

(45) Bekanntmachung des Hinweises auf die
Patenterteilung:
**08.12.93 Patentblatt  93/49**

(84) Benannte Vertragsstaaten:
**AT BE CH DE ES FR GB GR IT LI NL SE**

(56) Entgegenhaltungen:
**EP-A- 0 175 888**
**US-A- 4 511 859**
**US-A- 4 651 103**
**US-A- 4 672 299**

(73) Patentinhaber: **SIEMENS AKTIENGESELL-
SCHAFT**
**Wittelsbacherplatz 2**
**D-80333 München(DE)**

(72) Erfinder: **Ernst, Wolfram, Dipl.-Ing.**
**Karl-Witthalm-Strasse 9**
**D-8000 München 70(DE)**

## Beschreibung

Die Erfindung betrifft ein Verfahren zur Synchronisation eines Taktes, insbesondere Vermittlungstaktes nach dem Oberbegriff des Anspruchs 1.

Internationale Digitalnachrichtenverbindungen sollen gemäß CCITT-Empfehlung G.811 mit einer langzeitigen relativen Frequenzabweichung kleiner $1 \times 10^{-11}$ betrieben werden, was etwa einem Rahmenschlupf in 70 Tagen enspricht. In plesiochronem, d.h. "freilaufendem" Betrieb kann diese Frequenzkonstanz nur mit aufwendigen Cäsium-Atomfrequenznormalen erreicht werden.

Um auch im nationalen Netz die empfohlene Frequenzkonstanz einzuhalten, bietet sich als wirtschaftlich und technisch günstige Lösung ein synchrones Digitalnetz an, bei dem die Taktgeneratoren der Vermittlungsstelle (ausgehend von einer zentralen Referenz- bzw. Normaltaktquelle) auf eine Referenzfrequenz $f_R$ synchronisiert werden, die von einem Netzknoten höherer oder gleicher Ordnung gesendet wird und zwar beispielsweise über eine mit diesem Netzknoten bestehende Digitalsignalverbindung. Im Falle der Unterbrechung einer solchen Verbindung wird die Referenzfrequenz auf einem Ersatzweg von einem anderen dieser Netzknoten geliefert.

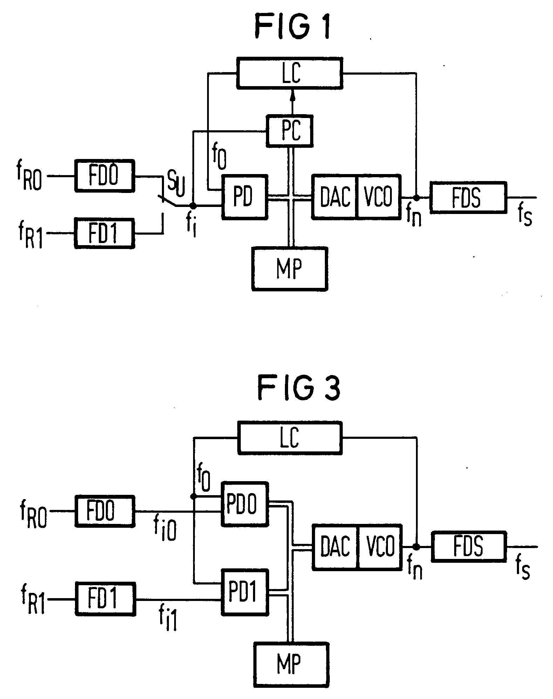

Es ist aus einem Sonderdruck der Zeitschrift "telcom report" der Siemens AG, 9. Jahrgang, Heft 4, Juli/August 1986, Seiten 263 bis 269, "Neue Taktgeneratoren für EWSD" von Ernst, W. und Hartmann, H.L. bekannt, für eine solche Synchronisierung einen digitalen Phasenregelkreis gemäß Fig.1 zu benutzen, dessen Aufbau und Funktion kurz beschrieben wird. Der durch einen Frequenzteiler FDS herabgeteilte Vermittlungstakt $f_S$ einer Vermittlungsstelle wird wahlweise auf einen von zwei Referenztakten $f_{R0}$ bzw. $f_{R1}$ synchronisiert, die wie dargelegt, von verschiedenen Vermittlungsstellen höherer oder gleicher Ordnung geliefert werden. Über die Frequenzteiler FD0 und FD1 liegt je nach Schalterstellung eines Umschalters $S_U$ einer der beiden Referenztakte als normierte Eingangsfrequenz $f_i$ am ersten Eingang eines Phasendiskriminators PD an. An dessen zweitem Eingang liegt die Vergleichsfrequenz $f_o$ an, die aus der Ausgangsfrequenz $f_n$ eines den Frequenzteiler FDS beaufschlagenden, spannungsgesteuerten Oszillators VCO über einen Schleifenzähler LC abgeleitet wird.

Aus der Phasendifferenz der beiden Frequenzen $f_i$ und $f_o$ wird entsprechend dem Regelalgorithmus der Verarbeitungseinheit MP ein Stellwert errechnet, der über einen Digital-Analog-Konverter DAC als Steuerspannung dem spannungsgesteuerten Oszillator zugeführt wird.

Die der Referenzfrequenz (Referenztakt) überlagerten Jitter- und Wanderstörungen werden dabei entsprechend CCITT-Rec.Q 502 behandelt, d.h. hochfrequente Jitterstörungen werden entsprechend einer Tiefpaßcharakteristik gedämpft, wogegen Wanderstörungen (daily wander) weitergegeben werden.

Bei erforderlichen Umschaltungen auf eine andere Referenzfrequenz (z.B. von $f_{R0}$ nach $f_{R1}$) oder bei Phasensprüngen der Eingangsfrequenz $f_i$ (ohne Umschalten) wird der Schleifenzähler über eine Phasenkorrektur PC rückgesetzt, so daß am Eingang des Phasendiskriminators die momentane Phasendifferenz zu Null gemacht wird. Der Rücksetzzeitpunkt wird dabei so gewählt, daß er mit einem Flankenwechsel des Eingangstaktes $f_i$ zusammenfällt. Dadurch soll vermieden werden, daß durch die Ausregelung des Phasensprungs unnötige Frequenzänderungen des Oszillators entstehen.

Allerdings geht durch diese Maßnahme auch gleichzeitig die ursprüngliche Phasenbeziehung zwischen der Eingangsfrequenz $f_i$ und der Vergleichsfrequenz $f_o$ verloren, die aufgrund des vorangegangenen Regelprozesses entstanden war. Zwar kann nach dem Rücksetzen des Schleifenzählers diese stationäre Phasenbeziehung allmählich (gemäß den Zeitkonstanten des Phasenregelkreises) wieder hergestellt werden, jedoch bewirken Störprozesse (z.B. Jitter, Wander, Alterung) während der Übergangsphase bis zur Wiederherstellung der stationären Phasenbeziehung eine bleibende Phasenabweichung. Selbst Phasenabweichungen, die nach der Übergangsphase bis zu ihrem stationären Wert wieder abgebaut würden (Jitter), werden dann zu bleibenden Phasenabweichungen, wenn innerhalb dieses Zeitraums der Schleifenzähler erneut rückgesetzt werden muß.

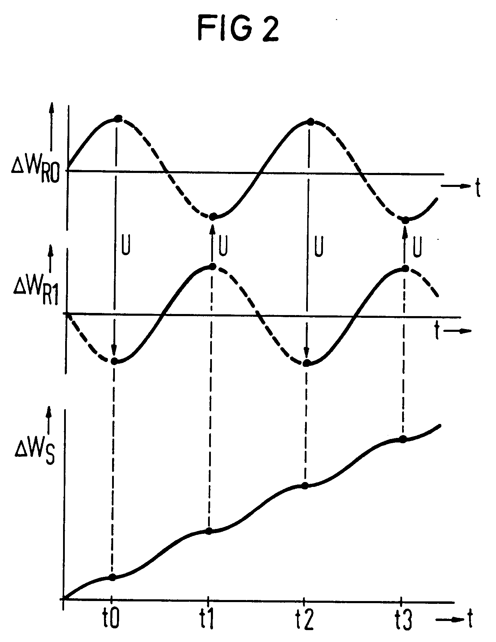

Bei einer erforderlichen Umschaltung besteht im Unterschied zum vorher beschriebenen Fall bereits vor dem durch die Umschaltung erzwungenen Rücksetzen keine Beziehung zwischen der Phasenlage des Vermittlungstaktes bzw. Vergleichstaktes $f_o$ und der Phase des neuen Referenztaktes. Im ungünstigsten Fall entsteht dadurch eine Akkumulation der Phasenabweichung nach Fig.2.

In Fig.2 wird angenommen, daß die zwei bei der Umschaltung U beteiligten Referenztakte $f_{R0}$ und $f_{R1}$ bedingt durch den Wander eine zeitlich genau gegenläufige periodische Phasenabweichung $\Delta w_{R0}$ und $\Delta w_{R1}$ gegenüber dem Normaltakt besitzen. Schaltet man nun gerade in den Zeitpunkten $t_0$, $t_1$, $t_2$, $t_3$ der maximalen Phasenabweichung um, so schwingt der Oszillator ständig mit einer etwas erhöhten Frequenz $f_n$, so daß sich die Phasenabweichung $\Delta w_s$ des Vermittlungstaktes $f_S$ gegenüber dem Normaltakt ständig vergrößert.

Statistisch kann die durch die Rücksetzvorgänge bedingte Akkumulation der Phasenabweichung $\Delta w_s$ mit dem Modell des Random Walk beschrieben werden. Dabei interpretiert man jeden Rücksetzvorgang als Störereignis mit einer mittleren Häufigkeit h und einer bleibenden mittleren Phasenabweichung $\pm \Delta w_s$. Die Standardabweichung $\delta$ der Phasenabweichung $\Delta w_s$ ergibt sich sodann gemäß nachfolgender Gleichung, wobei der Parameter t die Zeit kennzeichnet.

$$\delta = 1/2 \times \Delta w_s \times \sqrt{h \times t}$$

Der Erfindung liegt die Aufgabe zugrunde, den Random Walk der Phase im Netz zu vermindern.

Diese Aufgabe wird bei einem gattungsgemäßen Verfahren durch die kennzeichnenden Merkmale des Anspruchs 1 gelöst.

Weitere Ausgestaltungen der Erfindung sind durch Unteransprüche gekennzeichnet.

Ein Ausführungsbeispiel der Erfindung ist in Fig.3 dargestellt und wird im folgenden näher beschrieben.

Fig. 3 zeigt einen digitalen Phasenregelkreis, wobei der durch den Frequenzteiler FDS herabgeteilte Vermittlungstakt $f_S$ wahlweise auf einen von zwei Referenztakten $f_{R0}$ und $f_{R1}$ synchronisiert werden soll.
Jedem der beiden Referenztakte ist über Frequenzteiler FD0 bzw. FD1 ein eigener Phasendiskriminator PD0 bzw. PD1 zugeordnet.
Das zweite Eingangssignal der beiden Phasendiskriminatoren, der Takt $f_o$, wird von einem Schleifenzähler LC geliefert, der in der Rückkopplungsschleife liegt und den Takt $f_n$ des spannungsgesteuerten Oszillators VCO herabteilt.
Ein die Verarbeitungseinheit darstellender Mikroprozessor MP empfängt die Ausgangssignale (Phasendifferenzen) der beiden Phasendiskriminatoren und speichert diese Daten für eine gewisse Zeitspanne (mehrere Regel- bzw. Stellwertperioden) ab.
Damit ist sowohl die momentane Phasenbeziehung beider Referenztakte $f_{R0}$ und $f_{R1}$ zum Vermittlungstakt $f_S$ bekannt, als auch deren Vorgeschichte. Durch Auswertung dieser Daten lassen sich bestimmte Kennwerte erfassen, wie beispielsweise Maxima/Minima der Phasendifferenz, zeitlicher Abstand der Umkehrpunkte oder die momentanen Werte der Phasenabweichungen und deren Richtungen. Aufgrund derartiger Kennwerte und geeigneter Rechenvorschriften ermittelt der Mikroprozessor einen Stellwert, den er dem Digital-Analog-Konverter DAC übergibt.
Der Digital-Analog-Konverter DAC wandelt seinerseits den vom Mikroprozessor erhaltenen digitalen Stellwert in einen analogen Stellwert für den Oszillator VCO um.

Bei der Ermittlung des Stellwertes berücksichtigt der Mikroprozessor folgende Besonderheiten:
Erkennt der Mikroprozessor beispielsweise durch Vergleich der Differenz zweier zeitlich aufeinanderfolgender von einem Phasendiskriminator erhaltener Phasenbeziehungen mit einem vorgegebenen Schwellwert einen Phasensprung, so korrigiert er den mit Hilfe der üblichen Rechenregel ermittelten Stellwert durch einen entsprechenden Offsetwert, damit eine unnötige Ausregelung der Phasendifferenz unterbleibt.

In den meisten Fällen werden sich nämlich Phasensprünge in eine Richtung durch Phasensprünge in entgegengesetzter Richtung kompensieren. Nur wenn die durch Phasensprünge angewachsene Phasenabweichung so groß geworden ist, daß die Gefahr eines Rahmenschlupfes besteht, wird der Mikroprozessor regelnd tätig. Durch die erwähnte Offsetwertbildung entfällt der bereits erwähnte Rücksetzvorgang, der einen Verlust der Phasenbeziehung und damit eine bleibende Phasenverschiebung wie vorher erläutert zur Folge hätte.

Das Gesagte gilt entsprechend auch im Falle des Umschaltens von einem Referenztakt auf den anderen. Der Mikroprozessor hat die zeitliche Abfolge von Phasenbeziehungen des Vermittlungstaktes gegenüber dem neuen Referenztakt bereits vor dem Umschalten abgespeichert.
Mit Hilfe geeigneter Rechenvorschriften läßt sich daraus ermitteln, welcher Anteil der momentanen Phasendifferenz auf Phasensprünge, welcher Anteil auf Wandereffekte und welcher Anteil auf sonstige Effekte (Jitter, Frequenzdrift) zurückgeht. Entsprechend bildet der Mikroprozessor Offsetwerte im Hinblick auf Phasensprünge und Korrekturwerte im Hinblick auf den Wander, so daß eine Akkumulation der Phasenabweichung wie z.B. nach Fig.2 weitgehend verhindert wird.

**Patentansprüche**

1. Verfahren zur Synchronisation eines von einem Taktgenerator erzeugten Taktes ($f_S$), insbesondere Vermittlungstaktes eines digitalen Zeitmultiplex-Fernmeldenetzes, auf den störbehafteten Referenztakt eines von mehreren zur Verfügung stehenden und voneinander unabhängigen, annähernd die gleiche Frequenz liefernden Referenztaktgebern mit Hilfe eines digitalen Phasenregelkreises, der von einer die Stellwerte zu dem Oszillator (VCO) des Phasenregelkreises liefernden Verarbeitungseinheit (MP) gesteuert wird,
**gekennzeichnet**
durch folgende Merkmale:
   a) Jedem Referenztakt ($f_{R0}$, $f_{R1}$) ist ein eigener Phasendiskriminator (PD0, PD1) zugeordnet,
   b) jeder Phasendiskriminator ermittelt permanent den Wert der Phasenbeziehung zwischen dem Referenztakt und dem vom Taktgenerator erzeugten Takt und übergibt diesen zur Speicherung an die Verarbeitungseinheit,

c) bei Phasensprüngen, die einen vorgegebenen Schwellwert übersteigen, ermittelt die Verarbeitungseinheit einen Stellwert, der einen Offsetwert beinhaltet, wodurch eine Ausregelung dieser Phasensprünge vermieden wird,

d) bei einer Umschaltung auf einen anderen Referenztakt steuert die Verarbeitungseinheit, aufgrund der von dem betreffenden Phasendiskriminator bereits vor der Umschaltung gelieferten Daten, das Aufsetzen auf diesen Referenztakt durch entsprechende Korrektur des Stellwertes dahingehend, daß eine Akkumulation der Phasenabweichung zwischen dem Referenztakt und dem Takt des Taktgenerators weitgehend vermieden wird.

2. Verfahren nach Anspruch 1,
**dadurch gekennzeichnet,**
daß die Verarbeitungseinheit (MP) nur im Falle einer erforderlichen Umschaltung in Bezug auf mindestens einen der übrigen Referenztakte (z.B. $f_{R1}$) einen Stellwert ermittelt.

3. Verfahren nach Anspruch 1,
**dadurch gekennzeichnet,**
daß die Verarbeitungseinheit (MP) in Bezug auf jeden der übrigen Referenztakte laufend Stellwerte ermittelt.

4. Verfahren nach Anspruch 2 oder 3,
**dadurch gekennzeichnet,**
daß die Verarbeitungseinheit (MP) aufgrund der genannten Stellwerte die Auswahl eines Referenztaktes aus den übrigen Referenztakten vornimmt.

## Claims

1. Method for synchronizing a clock pulse ($f_S$) generated by a clock-pulse generator, in particular a switching clock pulse of a digital time-division multiplex telecommunication network, to the interference-prone reference clock pulse of one of a plurality of available reference clock pulse generators which are independent of one another and supply approximately the same frequency, with the aid of a digital phase-locked loop which is controlled by a processing unit (MP) which supplies the control values to the oscillator (VCO) of the phase-locked loop, characterized by the following features:

a) each reference clock pulse ($f_{R0}$, $f_{R1}$) is assigned its own phase discriminator (PD0, PD1),

b) each phase discriminator permanently determines the value of the phase relationship between the reference clock pulse and the clock pulse generated by the clock pulse generator and relays the latter pulse to the processing unit for storage,

c) in the event of sudden phase changes which exceed a prescribed threshold value, the processing unit determines a control value which contains an offset value, as a result of which correction of these sudden phase changes is avoided,

d) when switching over to a different reference clock pulse, the processing unit controls the setting to this reference clock pulse on the basis of the data already supplied by the relevant phase discriminator for the switchover, doing so by appropriate correction of the control value to the effect that accumulation of the phase deviation between the reference clock pulse and the clock pulse of the clock pulse generator is largely avoided.

2. Method according to Claim 1, characterized in that the processing unit (MP) determines a control value only in the case of a required switchover with respect to at least one of the remaining reference clock pulses (for example, $f_{R1}$).

3. Method according to Claim 1, characterized in that the processing unit (MP) determines control values continuously with respect to each of the remaining reference clock pulses.

4. Method according to Claim 2 or 3, characterized in that the processing unit (MP) performs the selection of a reference clock pulse from the remaining reference clock pulses on the basis of the said control values.

## Revendications

1. Procédé pour synchroniser une cadence ($f_S$) produite par un générateur de cadence, notamment une cadence de commutation d'un réseau de télécommunication numérique à multiplexage temporel, sur la cadence de référence perturbée d'un parmis plusieurs générateurs de cadences de référence, qui sont disponibles, qui sont indépendants les uns des autres et qui fournissent approximativement la même fréquence, à l'aide d'une boucle à verrouillage de phase, qui est commandée par une unité de traitement (MP), qui fournit les valeurs de réglage à l'oscillateur (VCO) de la boucle à verrouillage de phase,
caractérisé par les caractéristiques suivantes :

a) un discriminateur de phase particulier (PD0, PD1) est associé à chaque cadence de référence ($f_{R0}$, $f_{R1}$),

b) chaque discriminateur de phase détermine en permanence la valeur de la relation de phase entre la cadence de référence et la cadence produite par le générateur de cadence, et transmet cette relation de phase, en vue de sa mémorisation, à l'unité de traitement,

c) dans le cas de sauts de phase, qui dépassent une valeur de seuil prédéterminée, l'unité de traitement détermine une valeur de réglage, qui contient une valeur de décalage, ce qui permet d'éviter une élimination par réglage de ces sauts de phase,

d) lors d'une commutation sur une autre cadence de référence, l'unité de traitement commande, sur la base des données déjà fournies par le discriminateur de phase considéré avant la commutation, le réglage sur cette cadence de référence au moyen d'une correction correspondante de la valeur de réglage de telle sorte qu'une accumulation de l'écart de phase entre la cadence de référence et la cadence du générateur de cadence est évitée dans une large mesure.

2. Procédé suivant la revendication 1, caractérisé par le fait que l'unité de traitement (MP) détermine une valeur de réglage uniquement dans le cas d'une commutation nécessaire, par rapport à au moins l'une des autres cadences de référence (par exemple $f_{R1}$).

3. Procédé suivant la revendication 1, caractérisé par le fait que l'unité de traitement (MP) détermine, en permanence, des valeurs de réglage, en rapport avec chacune des autres cadences de référence.

4. Procédé suivant la revendication 2 ou 3, caractérisé par le fait que l'unité de traitement (MP) exécute la sélection d'une cadence de référence à partir des autres cadences de référence, sur la base desdites valeurs de réglage.

EP 0 353 616 B1

# FIG 1

# FIG 3

# FIG 2